# EUROPEAN PATENT SPECIFICATION

(11) **EP 4 185 080 B1**
(45) Date of publication and mention of the grant of the patent: **01.01.2025**
(21) Application number: 21209001.3
(22) Date of filing: 18.11.2021
(51) Int. Cl.: H05K 5/02, H05K 5/00, H01R 24/50

(54) **RF CONNECTION SYSTEM, ELECTRONIC DEVICE**
HF-VERBINDUNGSSYSTEM, ELEKTRONISCHE VORRICHTUNG
SYSTÈME DE CONNEXION RF, DISPOSITIF ÉLECTRONIQUE

(43) Date of publication of application: 24.05.2023
(73) Proprietor: Rohde & Schwarz GmbH & Co. KG, 81671 München (DE)
(72) Inventor: Leipold, Markus, 84424 Isen (DE); Huber, Florian, 81735 Munich (DE)
(74) Representative: Novagraaf Group

(56) References cited:
- US-A1- 2002 171 994

## Description

### TECHNICAL FIELD

The present invention relates to an RF connection system for contacting a printed circuit board. The present invention further relates to an electronic device having such an RF connection system.

### BACKGROUND

Radio frequency (RF) connectors can be mounted to printed circuit boards (PCB) of electronic devices, e.g. measurement instruments, in order to contact the respective apparatus with coaxial cables or the like. On the one hand, it is beneficial if the installation process of these connectors is kept as quick and simple as possible without the need for complex and expensive mounting tools. On the other hand, the mechanical and electrical contact should be stable and durable. Amongst others, the RF connection should be reasonably free of mechanical stress.

Such a PCB may be accommodated within a cover or enclosure, e.g. of a device housing, which may be used to dissipate heat from the PCB. Consequently, if an RF connector is attached directly at or near such a part of the enclosure, the temperature may rise also at contact surfaces of the RF connector.

DE 10 2008 022 100 A1 describes a coaxial connector with thermal decoupling.

US 7,018,216 B1 describes a coaxial connector for a PCB for providing a reliable signal connection to the PCB while isolating the PCB from mechanical loads that are applied to the connector.

WO 02/093624 A2 describes an apparatus for regulating temperature of a process kit in a semiconductor wafer-processing chamber.

### SUMMARY

Against this background, there is a need to find solutions for thermally decoupled RF connections to PCBs that are resilient against mechanical stress and yet simple in construction.

To this end, the present invention provides an RF connection system and an electronic device with the features of the independent claims.

According to a first aspect of the invention, an RF connection system for contacting a printed circuit board (PCB) comprises an RF connector configured to be mounted to the PCB; and a mounting element configured to be mounted between a heat sink of the PCB and the RF connector to thermally decouple the RF connector from the heat sink, wherein the mounting element comprises at least one alignment interface for aligning the RF connector with respect to the heat sink. The mounting element comprises a thermally insulating material. The at least one alignment interface comprises several fastening portions for fastening the RF connector to the mounting element the mounting element to the heat sink, respectively. Each fastening portion is configured as a fastening hole for receiving a fastening element.

According to a second aspect of the invention, an electronic device comprises a PCB; a heat sink connected to the PCB and configured to dissipate heat generated by the PCB; and an RF connection system according to the invention mounted between the heat sink and the PCB.

The present invention is based on the insight that both thermal and mechanical stability can be achieved in a very simple manner by decoupling the RF connector from the heat sink with a mechanical element that can be used at the same time to align the RF connector relative to the heat sink. Mechanical tolerances can thus be compensated and the mechanical rigidity of the connection between the RF connector and the electronic device can be improved on a general level.

Further embodiments of the present invention are subject of the subordinate claims and of the following description, referring to the drawings.

According to the invention, the mounting element comprises a thermally insulating material.

For example, the mounting element may comprise and/or be made of a plastic or composite material with relatively low thermal conductivity and yet high rigidity. On the other hand, also metal materials, that is, metals, metal alloys or metal composites, may be suitable in case their thermal conductivity is relatively low (e.g. steel in contrast to aluminum alloys that are usually used for heat sinks due to their very high thermal conductivity).

According to the invention, the at least one alignment interface comprises several fastening portions for fastening the RF connector to the mounting element and the mounting element to the heat sink, respectively.

Each fastening portion may be used individually to compensate tolerances between the RF connector and the heat sink and/or to align both components with each other.

According to the invention, each fastening portion is configured as a fastening hole for receiving a fastening element.

According to an embodiment of the invention, the PCB may be configured with at least one groove or elongated hole running alongside a mounting portion of the PCB, on which the RF connector is mounted to the PCB.

For example, two elongated holes, grooves or slits may run along both sides of the mounted RF connector basically parallel to a plug-in direction of the connector, that is, perpendicular to the direction of maximal stress (e.g. in case of joggling or pulling at a plugged-in cable). These structures may help to compensate, for example, for distortions and other mechanical stress when assembling the mounting element, the heat sink and the RF connector within the electronic device. On the other hand, such mechanical stress may also be relocated to areas of the PCB where they are not an issue in order to keep away mechanical loads from the RF connector and the mounting portion of the PCB.

According to an embodiment of the invention, the mounting element may be configured with at least one tooth configured to engage the at least one groove or elongated hole to deflect mechanical stress from the mounting portion.

In a particular example, the mounting element may be configured as a plate arranged horizontally on a recess of the heat sink (e.g. a housing) and having several protrusions at an underside (e.g. teeth or webs), which may engage corresponding slits or holes within the PCB adjacent to the installed RF connector in order to deflect and compensate any mechanical stress occurring at the mounting portion of the PCB.

According to an embodiment of the invention, the heat sink may be a thermally conductive enclosure of the PCB.

In an example, an upper or lower cover shell of the housing may serve as heat sink and may be made from a highly conductive material in order to dissipate heat, e.g. an aluminum alloy. The cover shell may feature a recess and/or opening into which the mounting element may be placed adjacent to the PCB with the RF connector.

### BRIEF DESCRIPTION OF THE DRAWINGS

For a more complete understanding of the present invention and advantages thereof, reference is now made to the following description taken in conjunction with the accompanying drawings. The invention is explained in more detail below using exemplary embodiments which are specified in the schematic figures of the drawings, in which:
- Fig. 1: shows an explosive perspective view of an electronic device with an RF connection system according to an embodiment of the present invention; and
- Fig. 2: shows an explosive perspective view of an electronic device with an RF connection system according to an-other embodiment of the present invention.

The appended drawings are intended to provide further understanding of the embodiments of the invention. They illustrate embodiments and, in conjunction with the description, help to explain principles and concepts of the invention. Other embodiments and many of the advantages mentioned become apparent in view of the drawings. The elements in the drawings are not necessarily shown to scale.

In the drawings, like, functionally equivalent and identically operating elements, features and components are provided with like reference signs in each case, unless stated otherwise.

### DETAILED DESCRIPTION OF THE DRAWINGS

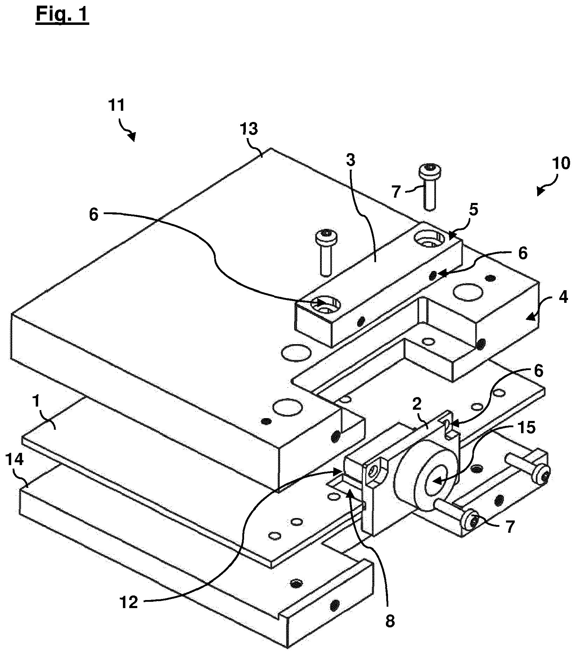

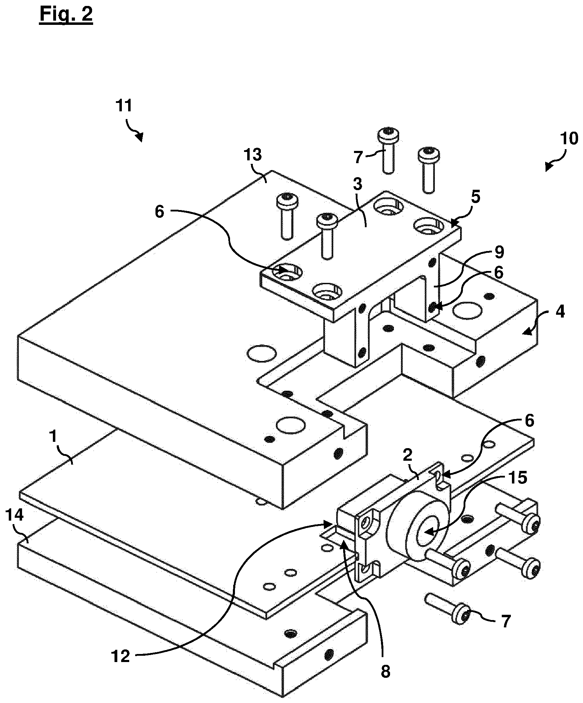

Figures 1 and 2 show explosive perspective views of electronic devices 11 being equipped with RF connection systems 10 according to embodiments of the present invention.

Radio frequency (RF) and/or coaxial connectors are a key component in RF and microwave applications where they are frequently used in test and measurement equipment to connect coaxial cables with the respective read-out or signal generating system components, e.g. in signal and spectrum analyzers and/or generators, test systems for antennas and other electromagnetic equipment, oscilloscopes etc. In most of these applications it is paramount to utilize connectors that allow accurate and repeatable measurements while being durable and highly performant at the same time.

In light of the above, a suitable RF connection should not only be easy to assemble in order to safe costs and manufacturing time but should also provide a connection that is mechanically and electrically stable.

On the other hand, outer portions of such measuring instruments (e.g. a cover, an enclosure, assembly portions, modules etc.) are often used as heat sinks for cooling the electronic circuits within the respective instrument. If an RF socket is connected directly to such a portion, high temperatures could occur at the RF socket that could adversely affect manual handling of these devices. Hence, also cooling issues should be taken into account when providing a suitable RF connector.

With reference to the embodiments shown in Figs. 1 and 2, electronic devices 11, e.g. measuring instruments, are described in the following that offer improvements to the above mentioned issues. In both cases, the respective electronic device 11 comprises a PCB 1 housed between an upper enclosure cover 13 and a lower enclosure cover 14. All three of these components are recessed on one side (right-hand side in Fig. 1) to accommodate the RF connection system 10.

In order to dissipate heat generated by the PCB 1 during operation, the upper enclosure cover 13 is made from a material with suitable thermal conductivity, e.g. an aluminum alloy or similar, such that it functions as a heat sink 4 for the PCB 1. However, it is to be understood that in other embodiments also the lower enclosure cover 14 may additionally or alternatively be provided with these properties accordingly.

Specifically, the RF connector 10 of the exemplary embodiments of Figs. 1 and 2 comprises an RF connector 2 mounted on top of the PCB 1 within a mounting portion of the PCB 1. The RF connector 2 may be an integrated component that is soldered (or otherwise fastened) to the PCB 1 as one part. However, the RF connector 2 may also be assembled from several subcomponents on top of the PCB 1, e.g. by first soldering a basic RF socket to the PCB featuring a pre-installed coaxial terminal and subsequently attach an RF port to the RF socket that may adapt the coaxial terminal for larger connectors/cables, for example.

The RF connector 10 provides a plug-in port 15 with a coaxial terminal inside (the latter is not visible in the figures). The RF connector 10 in the shown embodiment features a small box-like or cuboid housing portion resting upon the mounting portion 12 of the PCB 1 and a plate-shaped flange portion arranged on an outer side of the electronic device 11 and having a cylindrical extension with a through-hole serving as plug-in port 15 for other RF connectors, via which coaxial cables and the like may contact the PCB 1. The PCB 1 is configured with two elongated holes 8 or slits running alongside the mounting portion 12 of the PCB 1, that is, adjacent to the RF connector 10 and parallel to a plug-in direction of the same.

The electronic devices 11 of Figs. 1 and 2 each further comprise a mounting element 3 mounted between the upper enclosure cover 13 serving as heat sink 4 and the RF connector 2 to thermally decouple the RF connector 2 from the heat sink 4. To this end, each mounting element 3 is formed from a thermally insulating material, e.g. plastic.

The mounting elements 3 of both embodiments are configured with alignment interfaces 5 for aligning the RF connector 2 with respect to the heat sink 4. More specifically, the alignment interfaces 5 comprise several fastening portions 6 configured as fastening holes for receiving fastening elements 7 in order to fasten the RF connector 2 to the mounting element 3 and the mounting element 3 to the heat sink 4, respectively. The alignment interfaces 5 thus serve as alignment and/or tolerance compensation means during installation of the assembly.

The purpose of the mounting elements 3 is thus twofold. On the one hand, they are used to thermally decouple the RF connector 2 from the heat sink 4. On top of that, they are used as alignment means to compensate potential tolerances within the assembly.

As can be seen in the figures, the mounting elements 3 are accommodated in a graded recess within the upper enclosure cover 13, which also features correspondingly formed fastening holes such that the mounting elements 3 may be fixed in the recess by means of fastening elements 7. It is to be understood of course that the depicted configurations are mere examples. In a similar vein, the mounting elements 3 could also be mounted in/on the lower enclosure cover 14 or in other portions of a housing of the electronic device 11.

As can be seen in Figs. 1 and 2, the mounting elements 3 are provided with different shapes in both embodiments. In the embodiment of Fig. 1, the mounting element 3 has an elongated rectangular bar-like shape where the fastening portions 6 are arranged at both distal ends (two on top for fixing the mounting element 3 to the upper enclosure cover 13 and two on a lateral side for attaching the RF connector 2).

In the embodiment of Fig. 2, the mounting element 3 has a plate-shaped upper portion resting on the graded recess in the upper enclosure cover 13 and fastened there by means of four fastening holes at each corner. Two teeth 9 protrude from a lower side of the plate-shaped portion, each tooth 9 configured with two fastening holes for attachment of the RF connector 10. The teeth 9 are adapted to engage the elongated holes 8 at each lateral side of the mounting portion 12. In this vein, mechanical stress may be deflected from the mounting portion 12. For example, mechanical loads induced in the RF connector 2 from the outside may be absorbed and/or compensated by the teeth 9 of the mounting element 3 such that mechanical stress can be kept away from the mounting portion 12.

The mounting element 3 in the embodiment of Fig. 2 thus further helps to compensate mechanical stress during assembly and operation to make sure that the soldered connection between the PCB 1 and the RF connector 2 does not suffer unnecessarily under mechanical loads.

### List of reference signs

- 1: printed circuit board (PCB)
- 2: RF connector
- 3: mounting element
- 4: heat sink
- 5: alignment interface
- 6: fastening portion
- 7: fastening element
- 8: elongated hole
- 9: tooth
- 10: RF connection system
- 11: electronic device
- 12: mounting portion
- 13: upper enclosure cover
- 14: lower enclosure cover
- 15: plug-in port

## Claims

1. RF connection system (10) for contacting a printed circuit board, PCB, (1), the RF connection system (10) comprising:
an RF connector (2) configured to be mounted to the PCB (1); and
a mounting element (3) configured to be mounted between a heat sink (4) of the PCB (1) and the RF connector (2) to thermally decouple the RF connector (2) from the heat sink (4), wherein the mounting element (3) comprises at least one alignment interface (5) for aligning the RF connector (2) with respect to the heat sink (4);
wherein the mounting element (3) comprises a thermally insulating material;
**characterized in that** the at least one alignment interface (5) comprises several fastening portions (6) for fastening the RF connector (2) to the mounting element (3) and the mounting element (3) to the heat sink (4), respectively;
wherein each fastening portion (6) is configured as a fastening hole for receiving a fastening element (7).

2. Electronic device (11), comprising:
a PCB (1);
a heat sink (4) connected to the PCB (1) and configured to dissipate heat generated by the PCB (1); and
an RF connection system (10) according to claim 1 mounted between the heat sink (4) and the PCB (1).

3. Electronic device according to claim 2, wherein the PCB (1) is configured with at least one groove or elongated hole (8) running alongside a mounting portion (12) of the PCB (1), on which the RF connector (2) is mounted to the PCB (1).

4. Electronic device according to claim 3, wherein the mounting element (3) is configured with at least one tooth (9) configured to engage the at least one groove or elongated hole (8) to deflect mechanical stress from the mounting portion (12).

5. Electronic device according to one of the claims 2 to 4, wherein the heat sink (4) is part of a thermally conductive enclosure (13, 14) of the PCB (1).

## Patentansprüche

1. HF-Verbindungssystem (10) zum Kontaktieren einer Leiterplatte, PCB, (1), das HF-Verbindungssystem (10) umfassend:
einen HF-Verbinder (2), der konfiguriert ist, um an der PCB (1) montiert zu werden; und
ein Montageelement (3), das konfiguriert ist, um zwischen einem Kühlkörper (4) der PCB (1) und dem HF-Verbinder (2) montiert zu werden, um den HF-Verbinder (2) von dem Kühlkörper (4) thermisch zu entkoppeln, wobei das Montageelement (3) mindestens eine Ausrichtungsschnittstelle (5) zum Ausrichten des HF-Verbinders (2) in Bezug auf den Kühlkörper (4) umfasst;
wobei das Montageelement (3) ein thermisch isolierendes Material umfasst;
**dadurch gekennzeichnet, dass**
die mindestens eine Ausrichtungsschnittstelle (5) mehrere Befestigungsabschnitte (6) zum Befestigen des HF-Verbinders (2) an dem Montageelement (3) beziehungsweise des Montageelements (3) an dem Kühlkörper (4) umfasst;
wobei jeder Befestigungsabschnitt (6) als ein Befestigungsloch zum Aufnehmen eines Befestigungselements (7) konfiguriert ist.

2. Elektronische Vorrichtung (11), umfassend:
eine PCB (1);
einen Kühlkörper (4), der mit der PCB (1) verbunden ist und konfiguriert ist, um Wärme, die durch die PCB (1) erzeugt wird, abzuleiten; und
ein HF-Verbindungssystem (10) nach Anspruch 1, das zwischen dem Kühlkörper (4) und der PCB (1) montiert ist.

3. Elektronische Vorrichtung nach Anspruch 2, wobei die PCB (1) mit mindestens einer Nut oder einem Langloch (8) konfiguriert ist, die entlang eines Montageabschnitts (12) der PCB (1) verläuft, an dem der HF-Verbinder (2) an der PCB (1) montiert ist.

4. Elektronische Vorrichtung nach Anspruch 3, wobei das Montageelement (3) mit mindestens einem Zahn (9) konfiguriert ist, der konfiguriert ist, um in die mindestens eine Nut oder das Langloch (8) einzugreifen, um mechanische Spannung von dem Montageabschnitt (12) abzuleiten.

5. Elektronische Vorrichtung nach einem der Ansprüche 2 bis 4, wobei der Kühlkörper (4) Teil einer thermisch leitfähigen Ummantelung (13, 14) der PCB (1) ist.

## Revendications

1. Système de connexion RF (10) destiné à entrer en contact avec une carte de circuit imprimé, (PCB) (1), le système de connexion RF (10) comprenant :
un connecteur RF (2) conçu pour être monté sur la PCB (1) ; et
un élément de montage (3) conçu pour être monté entre un dissipateur thermique (4) de la PCB (1) et le connecteur RF (2) pour désaccoupler thermiquement le connecteur RF (2) du dissipateur thermique (4), dans lequel l'élément de montage (3) comprend au moins une interface d'alignement (5) permettant d'aligner le connecteur RF (2) par rapport au dissipateur thermique (4) ;
dans lequel l'élément de montage (3) comprend un matériau thermiquement isolant ;
**caractérisé en ce que**
l'au moins une interface d'alignement (5) comprend plusieurs parties de fixation (6) permettant de fixer le connecteur RF (2) à l'élément de montage (3) et l'élément de montage (3) au dissipateur thermique (4), respectivement ;
dans lequel chaque partie de fixation (6) est conçue comme un trou de fixation destiné à recevoir un élément de fixation (7).

2. Dispositif électronique (11) comprenant :
une PCB (1);
un dissipateur thermique (4) relié à la PCB (1) et conçu pour dissiper la chaleur générée par la PCB (1) ; et
un système de connexion RF (10) selon la revendication 1, monté entre le dissipateur thermique (4) et la PCB (1).

3. Dispositif électronique selon la revendication 2, dans lequel la PCB (1) est conçue avec au moins une rainure ou un trou allongé (8) longeant une partie de montage (12) de la PCB (1), partie de montage sur laquelle le connecteur RF (2) est monté sur la PCB (1).

4. Dispositif électronique selon la revendication 3, dans lequel l'élément de montage (3) est conçu avec au moins une dent (9) conçue pour venir en prise avec au moins une rainure ou un trou allongé (8) afin de dévier la contrainte mécanique de la partie de montage (12).

5. Dispositif électronique selon l'une des revendications 2 à 4, dans lequel le dissipateur thermique (4) fait partie d'une enceinte thermoconductrice (13, 14) de la PCB (1).
